# EUROPÄISCHE PATENTSCHRIFT

(11) **EP 0 782 171 B1**
(45) Veröffentlichungstag und Bekanntmachung des Hinweises auf die Patenterteilung: **12.07.2000**
(21) Anmeldenummer: 96118984.2
(22) Anmeldetag: 27.11.1996
(51) Int. Cl.: H01J 37/32

(54) **Schaltungsanordnung zum Betrieb einer Glimmentladungsstrecke**
Glow discharge controlling circuit
Circuit de commande d'un appareil à décharge luminescente

(30) Priorität: 29.12.1995 DE 29520685 U
(43) Veröffentlichungstag der Anmeldung: 02.07.1997
(73) Patentinhaber: Strämke, Siegfried, Dr., D-52538 Selfkant (DE)
(72) Erfinder: Strämke, Siegfried, Dr., D-52538 Selfkant (DE)
(74) Vertreter: Selting, Günther, Dipl.-Ing.

(56) Entgegenhaltungen:
- US-A- 4 645 981
- US-A- 4 709 188
- US-A- 5 286 360

## Beschreibung

Die Erfindung betrifft eine Schaltungsanordnung zum Betrieb einer Glimmentladungsstrecke mit zwei die Glimmentladungsstrecke bildenden Elektroden und einer Zündimpulsschaltung, welche Spannungsimpulse liefert, die jeweils eine Impulsspitze und anschließend einen Bereich zur Aufrechterhaltung der Glimmentladung ausreichender Amplitude aufweisen.

Eine derartige Schaltungsanordnung ist bekannt aus DE 33 22 341 C2. Diese Schaltungsanordnung liefert im Anfangsbereich eines jeden Impulses eine Impulsspitze, die größer ist als die Zündspannung der Glimmentladung. Wenn mit dieser kurzzeitigen Impulsspitze die Glimmentladung gezündet ist, wird sie im weiteren Verlauf des Spannungsimpulses durch eine Spannung mit niedrigerer Amplitude aufrechterhalten. Durch diese niedrigere Spannung, die unterhalb der Zündspannung der Glimmentladungsstrecke liegen kann, werden Entladungen niedriger spezifischer Leistungen möglich, welche gut regelbar sind.

Glimmentladungen werden häufig zur Oberflächenbehandlung von Werkstücken benutzt. Dabei wird die eine Elektrode mit dem Werkstück und die andere Elektrode mit der Wand eines das Werkstück umgebenden Reaktors oder einer im Reaktor befindlichen Gegenelektrode verbunden. Diejenige Elektrode, die als Kathode geschaltet ist, wird während der Glimmentladung mit Ionen aus dem Entladungsplasma bombardiert und dadurch gereinigt, d.h. von Fremdablagerungen befreit. Solche Fremdablagerungen können sowohl auf dem Werkstück als auch an der Gegenelektrode auftreten. Sie können durch Dampfablagerungen von Fremdstoffen entstehen, die am Werkstück oder in Poren des Werkstückes enthalten sind, und während der Glimmentladung verdampfen. In der Regel werden die Werkstücke kathodisch angeschlossen, so daß während der Glimmentladung die Werkstückoberfläche gereinigt wird.

Der Erfindung liegt die Aufgabe zugrunde, eine Schaltungsanordnung zum Betrieb einer Entladungsstrecke zu schaffen, die eine Reinigung sowohl der Werkstückfläche als auch der Gegenelektrode ermöglicht, ohne daß ein Umklemmen der Elektroden (Werkstück und Gegenelektrode) erforderlich ist.

Die Lösung dieser Aufgabe erfolgt erfindungsgemäß mit den im Patentanspruch 1 angegebenen Merkmalen.

Die erfindungsgemäße Schaltungsanordnung enthält eine Brückenschaltung, die in jedem Brückenzweig einen Polaritätsschalter und eine Zündimpulsschaltung enthält.

Die Glimmentladungsstrecke ist in dem Querzweig der Brückenschaltung enthalten. Jede Zündimpulsschaltung ist dann zur Lieferung von Spannungsimpulsen gesteuert, wenn der ihr zugeordnete, in dem anderen Brückenzweig liegende Polaritätsschalter im leitenden Zustand ist. Von den beiden Polaritätsschaltern ist stets einer im leitenden und einer im nichtleitenden Zustand, d.h. die Polaritätsschalter sind wechselseitig eingeschaltet. Diejenige Zündimpulsschaltung, die dem leitenden Polaritätsschalter in der Brückenschaltung diagonal gegenüberliegt, wird zur Erzeugung der Spannungsimpulse gesteuert. Durch Umschalten der Polaritätsschalter und Steuerung der zugehörigen Zündimpulsschaltung wird erreicht, daß jede der beiden Elektroden wahlweise kathodisch oder anodisch betrieben werden kann. Auf diese Weise ist es möglich, wahlweise entweder die eine oder die andere Elektrode während der Glimmentladung zu reinigen. Ein Umklemmen der Elektroden ist hierzu nicht erforderlich. Die Reinigung erfolgt durch geeignete Steuerung der in der Brückenschaltung enthaltenen Schalter durch ein entsprechendes Kontrollgerät, das einen Steuerschalter aufweist, mit dem bestimmt werden kann, welche der Elektroden bei der Glimmentladung die Kathode und welche die Anode bildet.

Ein besonderer Vorteil besteht darin, daß die Zündimpulsschaltung jeweils kurzzeitige Impulsspitzen liefert, die oberhalb der Zündspannung der Glimmentladungsstrecke laufen, und dann in Spannungsimpulse von geringerer Amplitude übergehen. Wenn bei der Umpolung lediglich Spannungsimpulse (ohne Impulsspitzen) umgepolt würden, müßte unter Umständen für jeden Polarisierungszustand eine andere Zünd- und Betriebsspannung gewählt werden, da die beiden Elektroden unterschiedliche Flächen und unterschiedliche Oberflächengestaltungen aufweisen können. Eine Elektrode, die spitze Konturen hat, zündet leichter als eine Elektrode mit ebenen Konturen. Außerdem wirkt sich die Temperatur der jeweiligen Elektrode auf das Zündverhalten aus. Infolge der Verwendung von Spannungsimpulsen mit aufgesetzten kurzzeitigen Impulsspitzen kann die Umpolung ohne eine Veränderung der Betriebsspannung durchgeführt werden, wobei in jedem Polarisierungszustand ein sicheres Zünden, ohne die Gefahr von Spannungsüberschlägen, sichergestellt ist.

Vorteilhafte Weiterbildungen und Ausgestaltungen der Erfindung sind der nachfolgenden Beschreibung eines Ausführungsbeispiels sowie den Unteransprüchen zu entnehmen.

Im folgenden wird unter Bezugnahme auf die Zeichnungen ein Ausführungsbeispiel der Erfindung näher erläutert.

Es zeigen:
- Fig. 1: ein schematisches Schaltbild der Schaltungsanordnung zum Betrieb einer Glimmentladungsstrecke und
- Fig. 2: die Impulsverläufe an ausgewählten Schaltungspunkten der Schaltung nach Fig. 1.

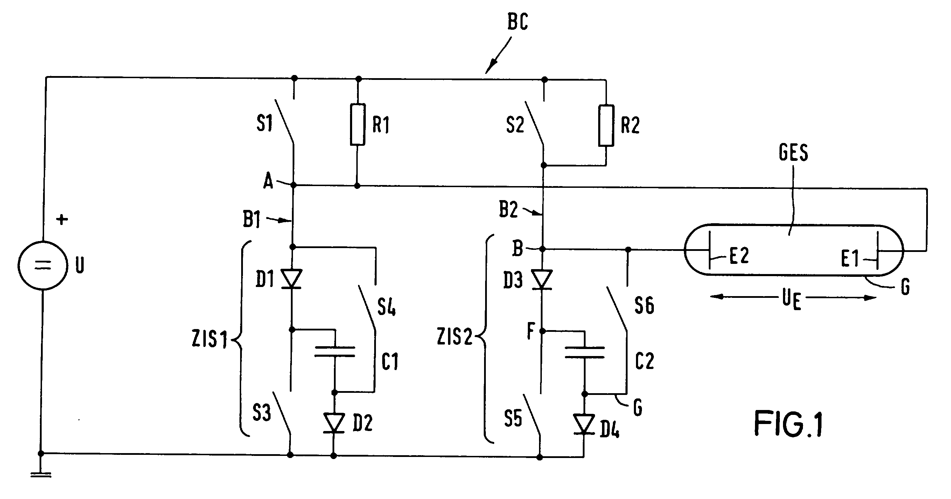

Die in Fig. 1 dargestellte Schaltungsanordnung weist eine Gleichspannungsquelle U auf, deren positiver Anschluß Pluspotential liefert, während der negative Anschluß mit Massepotential verbunden ist. Die Gleichspannungsquelle U ist an eine Brückenschaltung BC angeschlossen, deren erster Brückenzweig B1 in Reihe die folgenden Komponenten enthält: einen Polaritätsschalter S1, eine erste Diode D1 und einen Schalter S3. Der Schalter S3 ist durch eine Reihenschaltung aus einem Kondensator C1 und einer mit ihrer Kathode an Massepotential liegenden zweiten Diode D2 überbrückt. Der Schaltungspunkt A, der den Polaritätsschalter S1 mit der Diode D1 verbindet, ist über einen Schalter S4 mit der Anode der Diode D2 verbunden. Der Polaritätsschalter S1 ist durch einen Widerstand R1 überbrückt.

Der zweite Brückenzweig B2 der Brückenschaltung BC ist in gleicher Weise ausgebildet und seine Komponenten sind in gleicher Weise bemessen wie der Brückenzweig B1. Der Polaritätsschalter S2 ist in Reihe mit einer ersten Diode D3 und einem Schalter S5 an die Spannungsquelle U angeschlossen. Der Schalter S5 ist durch eine Reihenschaltung eines Kondensators C2 und einer zweiten Diode D4 überbrückt. Der Verbindungspunkt B des Schalters S2 mit der Diode D3 ist über einen Schalter S6 mit der Anode der Diode D4 verbunden. Der Polaritätsschalter S2 ist durch einen Widerstand R2 überbrückt.

Derjenige Teil des Brückenzweiges B1, der zwischen dem Verbindungspunkt A und Massepotential liegt, bildet eine Zündimpulsschaltung ZIS1 und derjenige Teil des zweiten Brückenzweiges B2, der zwischen dem Verbindungspunkt B und Massepotential liegt, bildet die Zündimpulsschaltung ZIS2.

Zwischen den Verbindungspunkten A und B erstreckt sich der Querzweig der Brückenschaltung, der eine Glimmentladungsstrecke GES enthält. Die Glimmentladungsstrecke GES wird durch zwei Elektroden E1 und E2 gebildet, wobei die Elektrode E1 mit dem Verbindungspunkt A und die Elektrode E2 mit dem Verbindungspunkt B verbunden ist. Die Glimmentladungsstrecke GES befindet sich im Innern eines evakuierten Behälters G, bei dem es sich um einen Reaktor handeln kann, der an eine Vakuumpumpe angeschlossen ist.

Sämtliche Schalter S1-S6 sind elektronische Schalter, die von einem (nicht dargestellten) Steuergerät gesteuert sind.

Die Polaritätsschalter S1 und S2 sind so gesteuert, daß jeweils nur einer dieser Schalter im leitenden Zustand ist. Es sei angenommen, daß der Polaritätsschalter S1 leitend ist, während der Polaritätsschalter S2 nichtleitend ist. Dann liegt an der Elektrode E1 die positive Spannung und an der Elektrode E2 liegt (über den Widerstand R2) zunächst ebenfalls positive Spannung, so daß die Spannung U_{E} zwischen den Elektroden der Glimmentladungsstrecke GES Null ist. Wenn der Polaritätsschalter S1 leitend ist, werden nur die Schalter S5 und S6 der Zündimpulsschaltung ZIS2 in der nachfolgend beschriebenen Weise gesteuert, während die Schalter S3 und S4 der Zündimpulsschaltung ZIS1 im nichtleitenden Zustand verbleiben, ebenso wie der Polaritätsschalter S2.

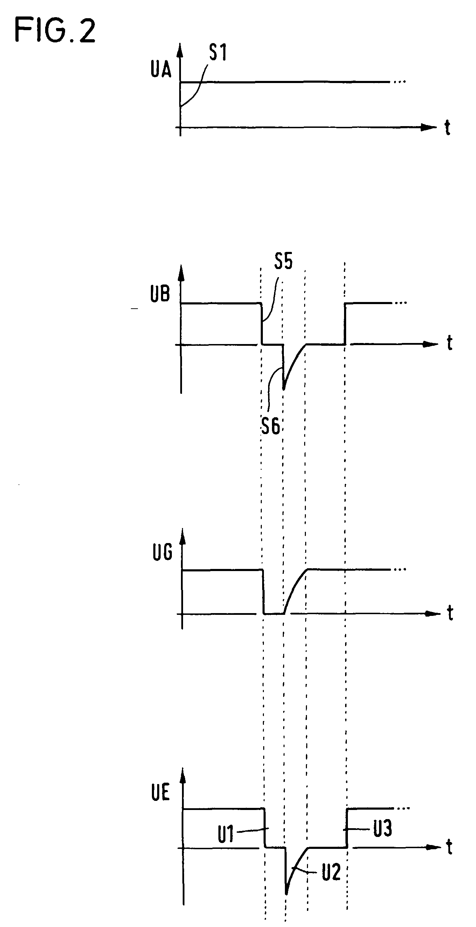

In Fig. 2 sind die Spannungsverläufe U_{A} am Verbindungspunkt A, U_{B} am Verbindungspunkt B, U_{G} am Verbindungspunkt G des Schalters S6 mit der Diode D4 und der Spannungsverlauf U_{E} an der Glimmentladungsstrecke GES dargestellt. Bei leitendem Polaritätsschalter S1 wird der Schalter S5 in den leitenden Zustand geschaltet, wodurch die Spannung U_{B} auf Massepotential sinkt. Da der Kondensator C2 seine Ladung beibehält, sinkt die Spannung U_{G} am Punkt G auf einen Wert, der negativer ist als Massepotential.

Wird danach der Schalter S6 ebenfalls in den leitenden Zustand geschaltet, entlädt sich der Kondensator C2, so daß die Spannung U_{G} auf Massepotential ansteigt. Gleichzeitig tritt während des Entladungsvorgangs am Verbindungspunkt B eine negative Spannungsspitze auf, die negativer ist als Massepotential.

Aus diesen Spannungsverläufen ergibt sich der in Fig. 2 dargestellte Spannungsverlauf U_{E} an der Glimmentladungsstrecke GES. Die Spannungsimpulse der Spannung U_{E} haben einen Bereich U1, in dem die Amplitude derjenigen der Versorgungsspannung U entspricht, danach eine Spannungsspitze U2, die auf die Entladung des Kondensators C2 zurückgeht, und anschließend einen Bereich U3, der wiederum die Amplitude der Versorgungsspannung U aufweist. Die Impulsspitze U2 dient dazu, zwischen den Elektroden E1 und E2 eine Glimmentladung zu zünden, während im Bereich U3 die Spannung so bemessen ist, daß sie lediglich zur Aufrechterhaltung der Glimmentladung ausreicht. Die Spannungsimpulse können einer variablen oder festen Basisspannung überlagert sein.

Bei der beschriebenen Polarität wird die Elektrode E1 als Anode und die Elektrode E2 als Kathode betrieben.

Während der Glimmentladung wird dadurch die Elektrode E2 gereinigt. Soll dagegen die Elektrode E1 gereinigt werden, dann wird der Polaritätsschalter S1 in den nichtleitenden Zustand und der Polaritätsschalter S2 in den leitenden Zustand gesteuert. Die Zündimpulserzeugung erfolgt mit der Zündimpulsschaltung ZIS1.

Die Versorgungsspannung U beträgt zwischen 200 und 2000 V und ist einstellbar. Die Dauer der Spannungsimpulse ist zwischen 0,1 und 10⁶ µs variabel, bei einer Pulswiederholzeit von 0,1 bis 10⁶ µs. Ferner können Einzelimpulse erzeugt werden.

Die erfindungsgemäße Schaltungsanordnung kann für alle Arten von Glimmentladungen angewandt werden, vorzugsweise bei der Bearbeitung von Werkstücken in einem Glimmentladungsreaktor, vorzugsweise bei der PVD- oder CVD-Beschichtung, beim Plasmanitrieren, Plasmaaufkohlen, Plasmaborieren, der Plasmareinigung, der Oberflächenmodifikation, z.B. dem Behandeln von organischen und anorganischen Stoffen, und in der Plasmachemie sowie vielen anderen Plasmaprozessen. Bei der Plasmabehandlung von Werkstücken kann die eine Elektrode mit dem Werkstück und die andere mit dem Behälter G verbunden werden. Es ist auch möglich, die Entladung zwischen zusätzlich eingebrachten Elektroden, z.B. Gittern oder zwischen diesen und der Wand bzw. dem Werkstück zu betreiben.

## Patentansprüche

1. Schaltungsanordnung zum Betrieb einer Glimmentladungsstrecke (GES) mit zwei die Glimmentladungsstrecke bildenden Elektroden (E1,E2) und einer Zündimpulsschaltung (ZIS1,ZIS2), welche Spannungsimpulse liefert, die jeweils eine Impulsspitze (U2) und anschließend einen Bereich (U3) mit zur Aufrechterhaltung der Glimmentladung ausreichender Amplitude aufweisen,
**dadurch gekennzeichnet,**
daß eine Brückenschaltung (BC) vorgesehen ist, die in jedem Zweig (B1,B2) einen Polaritätsschalter (S1,S2) und eine Zündimpulsschaltung (ZIS1,ZIS2) enthält, daß die Glimmentladungsstrecke (GES) im Querzweig der Brückenschaltung (BC) enthalten ist, und daß jede Zündimpulsschaltung (ZIS1,ZIS2) dann zur Lieferung von Spannungsimpulsen gesteuert ist, wenn der ihr zugeordnete, in dem anderen Brückenzweig liegende Polaritätsschalter (S1,S2) im leitenden Zustand ist.

2. Schaltungsanordnung nach Anspruch 1, dadurch gekennzeichnet, daß jedem Polaritätsschalter (S1,S2) ein Widerstand (R1,R2) parallelgeschaltet ist.

3. Schaltungsanordnung nach Anspruch 1 oder 2, dadurch gekennzeichnet, daß jede Zündimpulsschaltung (ZIS1,ZIS2) einen mit einer ersten Diode (D1,D3) in Reihe liegenden ersten Schalter (S3,S5), eine den ersten Schalter überbrückende Reihenschaltung mit einem Kondensator (C1,C2) und einer zweiten Diode (D2,D4) und einen die zweite Diode mit der einen Elektrode (E2) verbindenden Schalter (S4,S6) aufweist.

4. Schaltungsanordnung nach einem der Ansprüche 1-3, dadurch gekennzeichnet, daß die Betriebsspannung (U) der Brückenschaltung (BC) in einem Bereich von 200 bis 2000 V veränderbar ist.

5. Schaltungsanordnung nach einem der Ansprüche 1-4, dadurch gekennzeichnet, daß die Dauer der Spannungsimpulse in einem Bereich von 0,1 10⁶ µs bis veränderbar ist.

6. Schaltungsanordnung nach einem der Ansprüche 1-5, dadurch gekennzeichnet, daß die Spannungsimpulse einer variablen oder festen Basisspannung überlagert sind.

## Claims

1. A circuitry for operating a glow discharge path (GES), comprising two electrodes (E1,E2) forming the glow discharge path and an ignition pulse circuit (ZIS1,ZIS2) supplying voltage pulses each having a pulse peak (U2) and subsequently a portion (U3) with an amplitude sufficient for maintaining the glow discharge,
wherein a bridge circuit (BC) is provided, which includes a polarity switch (S1,S2) and an ignition pulse circuit (ZIS1,ZIS2) in each branch thereof, wherein the glow discharge path (GES) is included in the transverse branch of the bridge circuit (BC), and wherein each ignition pulse circuit (ZIS1,ZIS2) is then controlled to supply voltage pulses when the polarity switch (S1,S2) allocated thereto and located in the other bridge branch is in the conducting state.

2. The circuitry according to claim 1, wherein each polarity switch (S1,S2) has a resistor (R1,R2) connected in parallel thereto.

3. The circuitry according to claim 1, wherein each ignition pulse circuit (ZIS1,ZIS2) comprises a first switch (S3,S5) arranged in series with a first diode (D1,D3), a series connection of a capacitor (C1,C2) and a second diode (D2,D4) bridging the first switch, and a switch (S4,S6) connecting the second diode to the one electrode (E2).

4. The circuitry according to claim 1, wherein the operating voltage (U) of the bridge circuit (BC) is variable in a range of from 200 to 2000 V.

5. The circuitry according to claim 1, wherein the duration of the voltage pulses is variable in a range of from 0.1 to 10⁶ µs.

6. The circuitry according to claim 1, wherein the voltage pulses are superimposed on a variable or a fixed base voltage.

## Revendications

1. Dispositif de commande pour l'exploitation d'une ligne à décharge luminescente (CES) comprenant deux électrodes (E1, E2), qui forment la ligne à décharge luminescente, et un circuit à impulsions d'amorçage (ZIS1, ZIS2) qui fournit des impulsions de tension qui comportent chacune une crête d'impulsion (U2), suivie d'une zone (U3) avec une amplitude suffisante pour maintenir la décharge luminescente, caractérisé en ce qu'il est prévu un circuit en pont (BC), qui contient dans chaque branche (B1, B2) un inverseur de polarité (S1, S2) et un circuit à impulsions d'amorçage (ZIS1, ZIS2), en ce que la ligne à décharge luminescente (GES) est montée dans la branche transversale du circuit en pont (BC), et en ce que chaque circuit à impulsions d'amorçage (ZIS1, ZIS2) est commandé pour fournir les impulsions de tension lorsque l'inverseur de polarité (S1, S2), qui lui est associé et qui est situé dans l'autre branche du pont, est en état conducteur.

2. Dispositif de commande selon la revendication 1, caractérisé en ce qu'une résistance (R1, R2) est branchée en parallèle avec chaque inverseur de polarité (S1, S2).

3. Dispositif de commande selon la revendication 1 ou 2, caractérisé en ce que chaque circuit à impulsions d'amorçage (ZIS1, ZIS2) comporte un premier commutateur (S3, S5) monté en série avec une première diode (D1, D3), un couplage série qui shunte le premier commutateur et qui contient un condensateur (C1, C2) et une deuxième diode (D2, D4), et un commutateur (S4, S6) qui relie la deuxième diode à l'une des électrodes (E2).

4. Dispositif de commande selon l'une quelconque des revendications 1 à 3, caractérisé en ce qu'il est possible de faire varier la tension de service (U) du circuit en pont (BC) dans une plage allant de 200 à 2 000 V.

5. Dispositif de commande selon l'une quelconque des revendications 1 à 4, caractérisé en ce que la durée des impulsions de tension est variable dans une plage allant de 0,1 à 10⁶ µs.

6. Dispositif de commande selon l'une quelconque des revendications 1 à 5, caractérisé en ce que les impulsions de tension sont superposées à une tension de base variable ou fixe.
